# EUROPÄISCHE PATENTSCHRIFT

(11) **EP 1 528 680 B1**
(45) Veröffentlichungstag und Bekanntmachung des Hinweises auf die Patenterteilung: **31.12.2008**
(21) Anmeldenummer: 04023255.5
(22) Anmeldetag: 29.09.2004
(51) Int. Cl.: H03K 17/968, G01D 5/36

(54) **Impulsgeber**
Pulse generator
Dispositif de génération d'impulsions

(30) Priorität: 03.11.2003 DE 10351560
(43) Veröffentlichungstag der Anmeldung: 04.05.2005
(73) Patentinhaber: KBA-METRONIC AG, 97209 Veitshöchheim (DE)
(72) Erfinder: Schmitt, Peter, Dipl.-Phys., 97074 Würzburg (DE)
(74) Vertreter: COHAUSZ DAWIDOWICZ HANNIG & SOZIEN

(56) Entgegenhaltungen:
- GB-A- 928 564
- US-A- 4 785 181
- US-A- 5 216 257
- US-A- 5 644 514
- PATENT ABSTRACTS OF JAPAN Bd. 2000, Nr. 06, 22. September 2000 (2000-09-22) & JP 2000 088606 A (FUTABA CORP), 31. März 2000 (2000-03-31)

## Beschreibung

Die Erfindung betrifft einen Impulsgeber umfassend wenigstens eine bewegbare Impulsgeberplatte mit sich periodisch wiederholenden Bereichen unterschiedlicher optischer Dichte, Reflexion oder Transparenz, die mittels wenigstens eines optischen Sensors detektierbar sind, der ein von einem detektierten Bereich abhängiges elektrisches Signal erzeugt und bei dem die Bereiche unterschiedlicher optischer Dichte, Reflexion oder Transparenz einer ersten Impulsgeberplatte mit einer ersten Periodizität mit den Bereichen unterschiedlicher optischer Dichte, Reflexion oder Transparenz einer zweiten Impulsgeberplatte mit einer zweiten Periodizität überlagert werden, wofür sich eine erste und eine zweite Impulsgeberplatte zumindest in einer Überlagerungszone überdecken, so dass wenigstens in einer Überlagerungszone ein Moiré-Muster unterschiedlicher optischer Dichte, Reflexion oder Transparenz mit wenigstens einer dritten Periodizität erzeugt und mit einem optischen Sensor detektierbar ist.

Derartige Impulsgeber, die auch als Encoder eingesetzt und bezeichnet werden sind geeignet, z.B. innerhalb eines bestimmten Bereiches eine Anzahl von Impulsen pro Umdrehung oder bei einem linearen Impulsgeber eine Anzahl von Impulsen pro Längeneinheit zu erzeugen.

Hierzu werden die sich mit einer gegebenen Periodizität wiederholenden Bereiche unterschiedlich optischer Dichte oder Transparenz einer sich bewegenden impulsgeberplatte mittels eines Sensors, z.B. einer Lichtschranke in Reflektions oder Durchlichtanordnung detektiert und in ein elektrisches Signal mit z.B. nacheinander auftretenden hohen und niedrigen Spannungswerten gewandelt. Das Signal, z.B. dessen Frequenz, Amplitude oder Anzahl der steigenden oder fallen Flanken, stellt dann z.B. ein Maß für die Schnelligkeit oder die Weite und ggf. der Richtung der Bewegung dar.

In vielen Maschine werden Impulsgeber eingesetzt, die z.B. als Drehimpulsgeber ausgeführt, in Abhängigkeit von einer Umdrehung einer Achse eine bestimmte Anzahl von Impulsen pro Umdrehung an ihrem elektrischen Ausgang liefern.

Solche Drehimpulsgeber, auch Encoder genannt, dienen beispielsweise dazu, Geschwindigkeiten von Maschinen oder Motoren zu messen und über eine geeignete elektronische Steuerung zu regeln, oder Positionen genau anzufahren. Kommerziell erhältliche Impulsgeber weisen dabei stets eine feste Anzahl von Impulsen/Umdrehung auf, die zudem im metrischen Maß ausgegeben werden wie beispielsweise 1000 Impulse pro Umdrehung, 5000 Impulse pro Umdrehung etc.

Besonders einfache Impulsgeber dieser Art sind auch aus der Anwendung in Computermäusen bekannt. Höherwertige Impulsgeber, teilweise als Lineargeber ausgeführt, finden sich in Bürodruckern, bevorzugt in Tintenstrahldruckern.

Beim Einbau eines solchen Impulsgebers in ein Getriebe mit einem festen Teilungsverhältnis ergeben sich so bezogen auf eine Länge keine einer zölligen Auflösung angepassten Werte wie z.B. 300 Punkte pro Zoll (dpi), 600 Punkte pro Zoll (dpi) etc.

Es existieren stets Abweichungen, die regelmäßig mehrere Prozent groß sind. Impulsgeber, welche bereits eine zöllige Auflösung besitzen, lassen sich wenn überhaupt nur mit einem erheblichen Aufwand herstellen. Es existieren zwar elektronische Schaltungen, die mit mehreren phasenverschobenen Ausgängen eines metrischen Impulsgebers über Multiplikation und Division annähernd eine zöllige Teilung erreichen, die Abweichungen vom Sollwert insbesondere innerhalb eines Multiplikations- und Teilungszyklusses können jedoch mehrere Prozent betragen.

Zudem treten diese Abweichungen bei Verwendung einer solchen elektronischen Schaltung aufgrund der verwendeten Algorithmen in der Regel nicht bei jedem Umlauf immer an derselben Stelle auf, was ein weiteres Problem darstellt.

Im Druckbereich werden Druckauflösungen jedoch immer in Dots-per-inch (dpi) angegeben, beispielsweise 300 dpi, 600 dpi, etc., wobei in den meisten Fällen die verwendeten Druckköpfe ebenfalls eine zöllige Auflösung aufweisen, so dass für ein optimales und verzerrungsfreies Druckergebnis in jede Druckrichtung eine zöllige Auflösung erforderlich ist. Soll ein solches oben genanntes System in einer Anwendung wie zum Beispiel innerhalb einer frei programmierbaren Druckmaschine als Taktgeber zur Druckauslösung der einzelnen Druckimpulse eingesetzt werden, so werden aufgrund der Abweichungen und Variationen unterschiedliche Verzerrungen, optisch sichtbare Schwebungen aufgrund der Variationen und bei mehrfarbigem Druck Passerprobleme auftreten.

Impulsgeber der eingangs genannten gattungsgemäßen Art sind z.B, aus der GB 928 564 A bekannt Dieses Dokument beschreibt ein Messverfahren zur Bestimmung der Bewegungsrichtung, Geschwindigkeit und des Weges, bei welcher eines der Gitter mitbewegt ist und ein zweites Gitter ggfs. noch zusätzlich eine Modulationsbewegung ausführen kann. Diese Bewegungen haben jedoch keinen Einfluß auf die Periodizität des durch die Überlagerung der Gitter erzeugten Moirémusters. Auch das Dokument US-A-5 216 257 betrifft Impulsgeber mit konstanter Periodizität.

Aufgabe der Erfindung ist es, einen Impulsgeber zu schaffen, welcher sich mit einfachen Mitteln stabil auf eine beliebige Anzahl von Impulsen pro Einheit, z.B. pro Umdrehung oder pro Längeneinheit einstellen lässt. Dabei sollen auch nicht ganzzahlige und irrationale Anzahlen von Impulsen pro Einheit möglich sein.

Diese Aufgabe wird gemäß der Erfindung dadurch gelöst, dass die Periodizität des Moirémusters durch eine Winkelveränderung einer ersten und einer zweiten Impulsgeberplatte zueinander individuell und immer wieder neu einstellbar ist.

Gemäß der Erfindung erfolgt die Überlagerung so, dass eine erste und eine zweite Impulsgeberplatte derart zueinander angeordnet sind, dass sie sich zumindest in einer Überlagerungszone überdecken, wobei in der Überlagerungzone aufgrund der Überlagerung der Bereiche erster und zweiter Periodizität ein Moirémuster mit wenigstens einer dritten Periodizität erzeugbar ist, insbesondere welches dann mit mindestens einem optischen Sensor detektierbar ist.

Hierbei kann die dritte Periodizität eine Funktion der Art der Überlagerung sein und aufgrund einer Beeinflussung dieser Art der Überlagerung variabel gestaltet sein. Unterschiedliche Arten der Überlagerung können sich z.B. durch unterschiedliche Ausrichtungen der Bereiche erster und zweiter Periodizität zueinander ergeben.

Ein Impulsgeber mit einer einstellbaren, variablen Impulszahl / Einheit ermöglicht es für eine gegebene mechanische Einrichtung, eine genau angepasste Anzahl von Impulsen pro Einheit (z.B. Umdrehung, Längeneinheit) einzustellen, um beispielsweise variable dpi-Zahlen mit sehr geringer Abweichung zum Sollwert zu realisieren oder um Anpassungen an ein bestehendes Getriebe vorzunehmen.

Hierfür kann in einer Ausführung bei einem Impulsgeber eine erste Impulsgeberplatte linear oder rotatorisch relativ wenigstens zu einer feststehenden zweiten Impulsgeberplatte und zu einem optischen Sensor bewegbar sein, wodurch sich Impulsgeber realisieren lassen, die sich zur Vermessung einer rotatorischen oder einer linearen Bewegung eignen.

Bevorzugt wird dafür ein Impulsgeber für lineare Bewegungen eine erste linear bewegbare Impulsgeberplatte aufweisen mit Bereichen unterschiedlicher optischer Dichte, Refelexion oder Transparenz, die in einem konstanten Abstand parallel zueinander angeordnet sind. Eine zweite Impulsgeberplatte kann ebenfalls bevorzugt Bereiche unterschiedlicher optischer Dichte, Reflexion oder Transparenz aufweisen, die in einem konstanten Abstand parallel zueinander angeordnet sind.

Ein Impulsgeber für rotatorische Bewegungen wird bevorzugt eine rotatorisch bewegbare Impulsgeberplatte mit Bereichen unterschiedlicher optischer Dichte, Reflexion oder Transparenz aufweisen, die auf einer Scheibe um den Mittelpunkt der Scheibe bevorzugt in radialer Richtung oder auch entlang einer Kurvenbahn angeordnet sind und zueinander einen konstanten Winkelabstand aufweisen. Eine zweite Impulsgeberplatte wird ebenfalls bevorzugt Bereiche unterschiedlicher optischer Dichte, Reflexion oder Transparenz aufweisen, wobei deren Anordnung und Form den Bereichen der ersten Impulsgeberplatte angepasst sein können.

In einer einfachen und bevorzugten Ausführung kann es vorgesehen sein, die Bereiche unterschiedlicher optischer Dichte, Reflexion oder Transparenz einer Impulsgeberplatte (sowohl der ersten als auch einer zweiten Platte) durch eine Vielzahl beabstandeter Linien oder Striche auf einem transparenten oder auch reflektierenden Trägermaterial auszubilden. Derartige Linien können z.B. durch eingravierte Rillen oder aufgetragene schwarze Linien/Striche realisiert sein oder durch andere Maßnahmen, die eine ortsvariable optische Dichte, Reflexion oder Transparenz erzeugen, die mittels Detektoren feststellbar ist.

Gemäß der Erfindung ist es vorgesehen, die Periodizität eines Moirémusters welches sich durch die Überlagerung der Bereiche unterschiedlicher optischer Dichte, Reflexion oder Transparenz zweier Impulsgeberplatten ergibt, durch eine Winkelveränderung einer ersten und einer zweiten Impulsgeberplatte zueinander zu ändern.

Dies hat den Vorteil, dass nicht nur werksmäßig vorgegebene beliebige Impulszahlen pro Einheit möglich sind, sondern dass ein Anwender je nach Anwendungsgebiet die Anzahl der Impulse pro Einheit (Umdrehung, Längeneinheit) individuell und immer wieder neu einstellen kann.

Hierfür kann es beispielsweise vorgesehen sein, dass eine relative Bewegung der Impulsgeberplatten zueinander manuell, insbesondere mittels einer Mikrometerschraube oder elektrisch gesteuert, insbesondere mittels eines Motors erzeugbar ist.

Durch die Überlagerung von Bereichen unterschiedlicher optischer Dichte, Reflexion oder Transparenz einer ersten und einer zweiten Periodizität, die auf zueinander benachbarten Impulsgeberplatten ausgebildet sind, wird ein Moirémuster erzeugt, welches wenigstens eine dritte Periodizität, ggf. noch eine weitere Periodiziät aufweist, wobei diese Periodizitäten in unterschiedlichen Richtungen im Moirémuster verlaufen können.

Im wesentlichen kann die Überlagerung und das damit erzeugte Moirémuster als Schwebung zwischen eng beieinanderliegenden Frequenzen (denen der Periodizitäten der Bereich) aufgefasst werden. Dementsprechend kann es in der Schwebung eine Summenfrequenz und eine Differenzfrequenz geben, die jeweils die unterschiedlichen Überlagerungsperiodizitäten im Moirémuster in unterschiedlichen Richtungen erklären.

In einer möglichen Ausgestaltung der zu überlagernden Periodizitäten kann beispielsweise vorgesehen sein, dass die Periodizitäten der Bereiche einer ersten Platte und einer zweiten Platte gleich sind. Eine Schwebung kann sich sodann z.B. durch eine Winkelverstellung einer Impulsgeberplatte zur anderen dadurch ergeben, da sich durch die Verdrehung die effektive Periodizität einer Impulsgeberplatte in einer Richtung betrachtet ändert.

Ausführungsbeispiele der Erfindung sind in den nachfolgenden Figuren dargestellt. Es zeigen:
- Figur 1+2:: einen Impulsgeber für lineare Bewegungen mit unterschiedlichen Winkelstellungen der zweiten Impulsgeberplatte;
- Figur 3+4:: einen Impulsgeber für rotatorische Bewegungen mit unterschiedlichen Winkelstellungen der zweiten Impulsgeberplatte;
- Figur 5.: einen Impulsgeber für rotatorische Bewegungen mit zwei weiteren Impulsgeberplatten die um eine drehbare erste Impulsgeberplatte angeordnet sind.

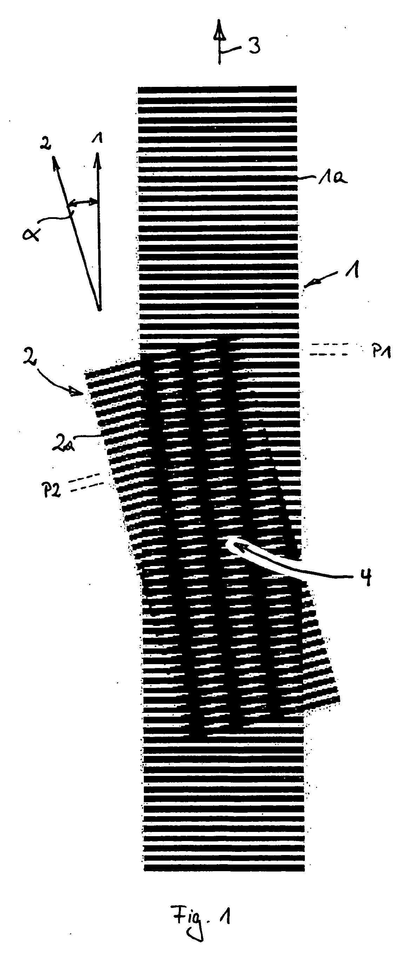

Die Figur 1 zeigt ein Beispiel für die Anordnung der Impulsgeberplatten 1 und 2 eines Impulsgebers für lineare Bewegungen, bei denen eine erste bewegliche Impulsgeberplatte 1 in Richtung des Pfeiles 3 linear bewegbar ist.

Diese Impulsgeberplatte ist in konventioneller Technik z.B. derart hergestellt, dass auf einem transparenten plattenförmigen Trägermaterial eine Vielzahl benachbarter zueinander paralleler Striche 1a mit einer Periodizität P1 angeordnet sind.

Unter einem Winkel α ist zu dieser Impulsgeberplatte 1 eine zweite Impulsgeberplatte 2 angeordnet, wobei sich diese beiden Platten zumindest in einer Zone überlappen, insbesondere übereinander angeordnet sind. Die zweite Impulsgeberplatte 2 weist ebenso Striche 2a mit einer Periodizität P2 auf. In diesem Ausführungsbeispiel sind die Periodizitäten P1 und P2 gleich, so dass sich bei einer Anordnung unter einem Winkel α=0 Grad effektiv eine übliche Impulsgeberanordnung ergibt.

Durch die hier gezeigte Winkelstellung α erreicht die Impulsgeberplatte 2 in Richtung des Pfeiles 3 eine andere effektiv wirkende Periodizität, so dass es in der Überlagerungszone 4 zu einem Moirémuster kommt, welches durch eine visuell wahrnehmbare Schwebung der Frequenzen bzw. Periodizitäten P1 und der effektiven Periodizität P2 erklärbar ist.

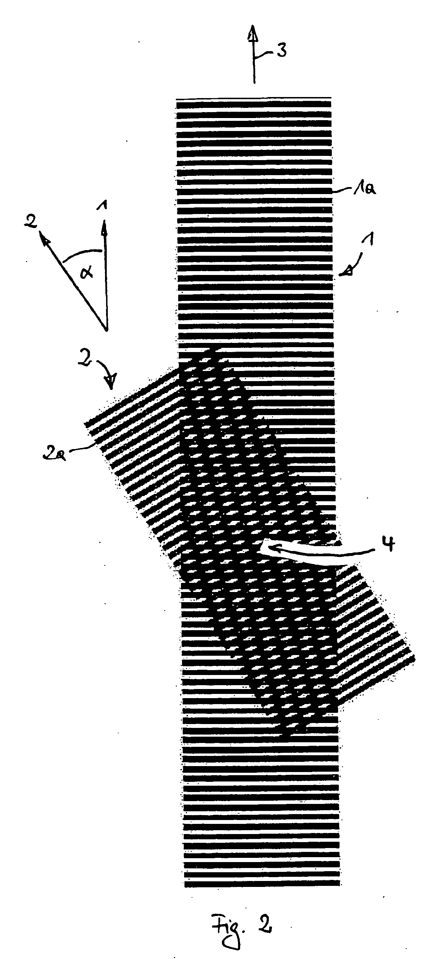

Hierbei ergibt sich eine Hell-Dunkelstruktur mit zwei verschiedenen Periodizitäten, eine in Richtung des halben Winkels α und eine senkrecht dazu. Diese durch die Überlagerung erhaltenen Periodizitäten können durch eine Änderung des Überlagerungswinkels a geändert werden, wie es aus Figur 2 ersichtlich ist, wo der Winkel α größer gewählt wurde.

Wird diese Änderung des Winkels a manuell, z.B. über Mikrometerschrauben oder elektrisch z.B. über Motoren vorgenommen, so kann eine beliebige Periodizität anwendungsbezogen eingestellt werden.

Bei derart in konventioneller Technik erzeugten Impulsgeberplatten, die im wesentlichen aus einem Strichgitter bestehen, und bei Überlagerung ein Moire erzeugen, dessen Schwebungsfrequenz neben den Teilungsfrequenzen der Strichgitter nur noch von dem Winkel zwischen Encoderscheibe und Strichgitter abhängt kann somit durch Variation des Winkels a eine beliebige Impulszahl / Längeneinheit erzeugt werden.

In dem Beispiel der Figur 1 sind die Strichgitter gleich oder in etwa gleich gewählt, um einen intensiven Moire Effekt zu erzeugen. Gleichzeitig wird unabhängig von dem Beispiel allgemein bevorzugt der Abstand der beiden Gitterebenen bzw. Impulsgeberplatten so gering als möglich eingestellt, um den Kontrast des Moires so intensiv wie möglich zu machen. Z.B. können sich die Impulsgeberplatten auch berühren

Ein in, über oder um die Überlappungszone 4 angebrachter optischer Sensor (z.B. Lichtschranke) erkennt die Hell-Dunkelschwankungen und liefert an seinem Ausgang ein entsprechendes elektrisches Signal. Das Signal selbst ist aufgrund des Schwebungsprinzips im wesentlichen sinusförmig, kann jedoch falls erforderlich durch eine einfache Komparatorschaltung in ein logisches Rechtecksignal umgewandelt werden.

Auch ist es möglich mindestens eine der Impulsgeberplatten in mehrere Bereiche zu unterteilen, wobei die Anordnung der genannten Hell- / Dunkelzonen der Bereiche zueinander phasenverschoben ist. Auf diese Weise lassen sich mit mehreren optischen Sensoren mehrere Ausgänge realisieren, die zueinander phasenverschoben sind, so dass die Bewegungsrichtung oder Drehrichtung elektronisch ermittelt werden kann. Vorgenannte Ausführungen gelten hierbei allgemein unabhängig von dem gezeigten Beispiel.

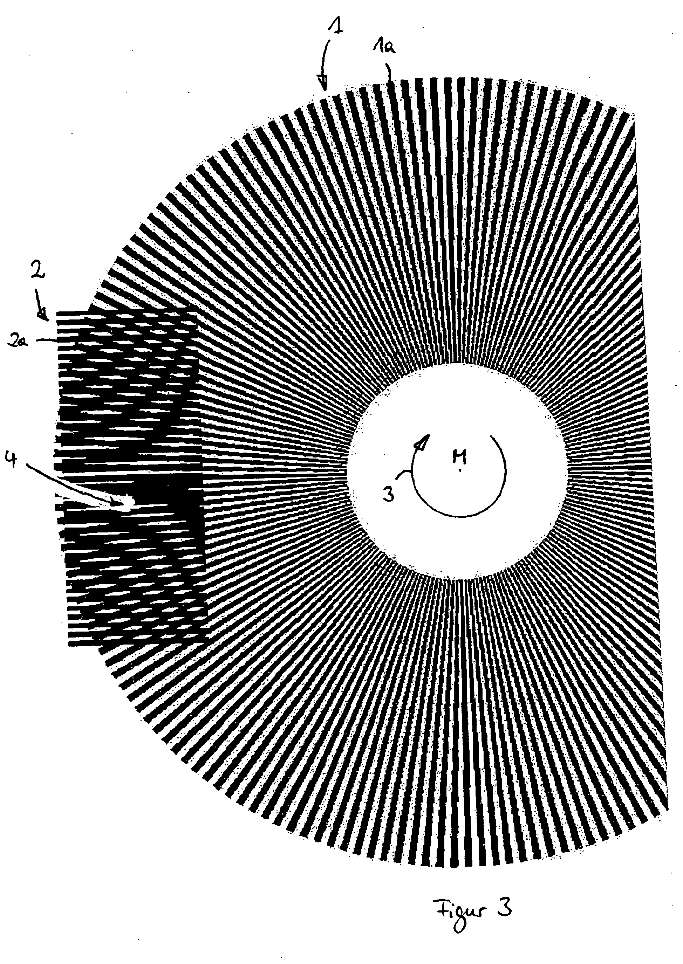

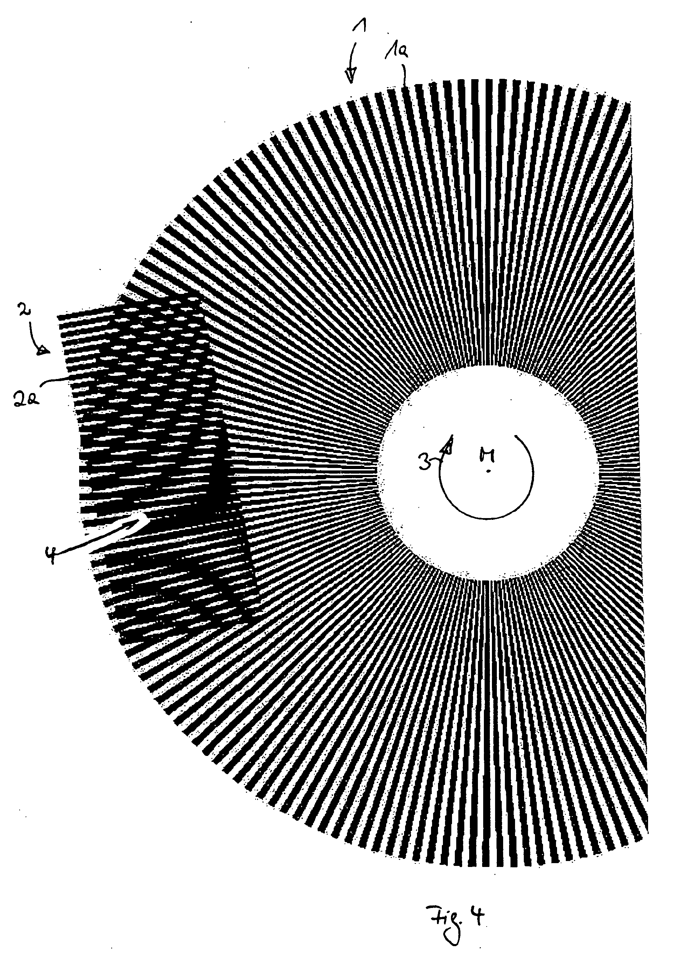

Die Figuren 3 und 4 zeigen eine beispielhafte Anordnung von Impulsgeberplatten 1 und 2 für einen Dreh-Impulsgeber. Hierbei weist die drehbare Impulsgeberplatte 1 eine Vielzahl von sich radial erstreckenden Strichen 1a auf, die in konstantem Winkelabstand angeordnet sind, der die Periodizität P1 dieser rotatorisch um den Mittelpunkt M bewegbaren Impulsgeberplatte 1 beschreibt.

Die Impulsgeberplatte 2 ist hier wie im Beispiel der Figuren 1 und 2 als Platte mit parallelen Strichen 2a aufgebaut. Die Impulsgeberplatte 2 ist in tangentialer Richtung unter einem Winkel von α=0 Grad zur linkseitigen Tangente an die Impulsgeberplatte 1 ausgerichtet. Im Überlappungsbereich 4 ergibt sich in diesem Fall aufgrund der nicht übereinstimmenden Periodizitäten ein unsymmetrisches Moirémuster mit wiederum verschiedenen Periodizitäten in unterschiedlichen Richtungen, die durch einen optischen Sensor in, über oder um die Überlappungszone 4 abgetastet werden können.

Die Figur 4 zeigt eine andere Winkelstellung a der zweiten Impulsgeberplatte 2 gegenüber der ersten Platte 1, wodurch sich die im Moirémuster erzeugten Periodizitäten ändern.

Eine Verdrehung der Impulsgeberplatten 2 in einen anderen Überlappungswinkel a bewirkt somit in beiden gezeigten Beispielen und unabhängig von diesen Beispielen ganz allgemein auch eine Veränderung des elektrischen Signals. Die Verdrehung bewirkt in der Regel auch keine ganzzahlige Anzahl von Impulsen pro Einheit, was für eine Anpassung von metrischen Einheiten zu zölligen Einheiten sogar erwünscht ist.

Die Schwebungsfrequenz zeigt sich in beiden Beispielen im Bereich der visuellen Überlappung nach außen als Zone mit hellen und dunklen Streifen, wobei die Streifen bei einer Verdrehung der runden Impulsgeberplatte 1 des zweiten Beispieles scheinbar in die Drehrichtung 3 wandern.

Die Verdrehung des Strichgitters der Impulsgeberplatte 2 kann bezogen auf beide Beispiele und allgemein bei jeder Realisierung der Erfindung in einer Ausführungsform mechanisch erfolgen, Hierzu ist die Impulsgeberplatte 2 auf einem Halter befestigt, der eine Drehachse senkrecht zur Impulsgeberplatte/Gitterebene besitzt. Eine von außen zugängliche Schraube oder Mikrometerschraube ist über einen Anschlag mit dem Halter verbunden und ermöglicht so eine beliebige Winkelveränderung der Strichscheibe 2 zu der Impulsgeberplatte 1.

In einer weiteren Ausführung kann die beschriebene Mikrometerschraube durch eine Stellmotor oder Schrittmotor oder ein Piezoelement mit hoher Auflösung ersetzt werden, um so zusätzlich eine Fernsteuerung der Ausgabefrequenz zu ermöglichen.

Ein derartiger Impulsgeber gemäß der Erfindung kann z.B. in einer Druckmaschine, insbesondere einer Rotationsdruckmaschine zur Detektion der Lage eines in der Druckmaschine bewegbaren Elementes Verwendung finden.

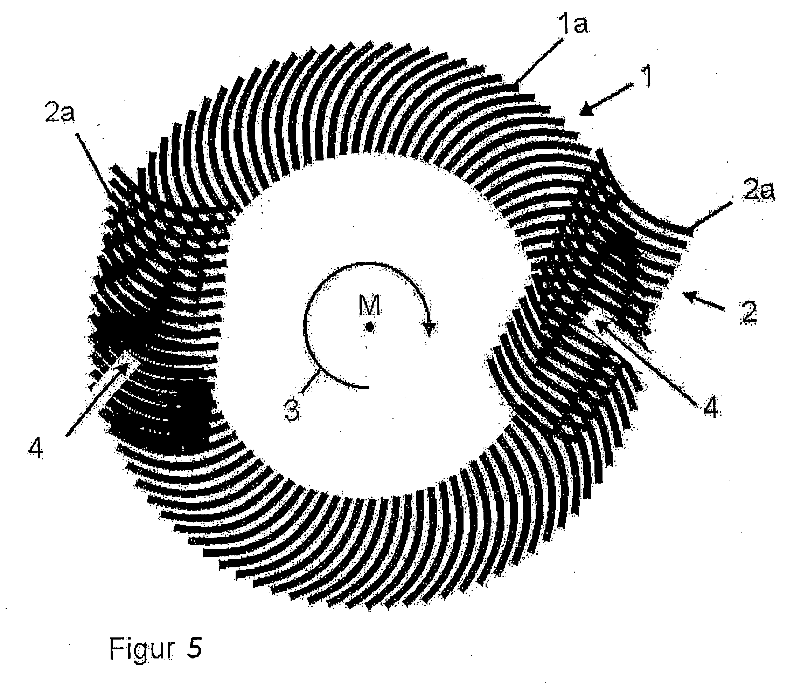

In einer weitem Ausführungsform wie schematisch in Figur 5 gezeigt, können mehrere Anordnungen mit jeweiligen Impulsgeberplatten (2) und jeweiligen in der Figur nicht gezeigten optischen Sensoren um die erste Impulsgeberplatte (1) angeordnet sein, um so beispielsweise gleichzeitig unterschiedliche Impulszahlen, die an unterschiedlichen Ausgängen zur Verfügung stehen zu erzeugen.

Figur 5 zeigt ebenfalls eine Ausführung die anstelle von geraden Strichen (1a, 2a) gekrümmte Striche verwendet um aufgrund der geometrischen Anpassung den Moire-Effekt zu optimieren. Vorteilhaft ist hierbei, dass zwischen den jeweiligen Ausgängen keine mechanische oder elektronische Umsetzung erforderlich ist, wodurch Genauigkeitsfehlern eliminiert werden. Vorteilhaft ist ebenfalls, dass durch eine einfache Anwahl des entsprechenden Impulsausganges, unterschiedliche und normalerweise nicht einfach zu realisierende Auflösungen zur Verfügung stehen können, wie beispielsweise 300 Impulse/inch, 254 Impulse/inch, 120 Impulse/cm, etc.

## Patentansprüche

1. Impulsgeber umfassend wenigstens eine bewegbare Impulsgeberplatte mit sich periodisch wiederholenden Bereichen unterschiedlicher optischer Dichte, Reflexion oder Transparenz, die mittels wenigstens eines optischen Sensors detektierbar sind, der ein von einem detektierten Bereich abhängiges elektrisches Signal erzeugt und bei dem die Bereiche unterschiedlicher optischer Dichte, Reflexion oder Transparenz einer ersten Impulsgeberplatte (1) mit einer ersten Periodizität (P 1) mit den Bereichen unterschiedlicher optischer Dichte, Reflexion oder Transparenz einer zweiten Impulsgeberplatte (2) mit einer zweiten Periodizität (P2) überlagert werden, wofür sich die erste und die zweite Impulsgeberplatte (1,2) zumindest in einer Überlagerungszone (4) überdecken, so dass wenigstens in der Überlagerungszone (4) ein Moiré-Muster unterschiedlicher optischer Dichte, Reflexion oder Transparenz mit wenigstens einer dritten Periodizität erzeugt und mit dem optischen Sensor detektierbar ist, **dadurch gekennzeichnet, dass** die Periodizität des Moirémusters durch eine Winkelveränderung (α) der ersten und der zweiten Impulsgeberplatte (1,2) zueinander individuell und immer wieder neu einstellbar ist.

2. Impulsgeber nach Anspruch 1, **dadurch gekennzeichnet, dass** die erste Impulsgeberplatte (1) linear oder rotatorisch relativ zu der zweiten Impulsgeberplatte (2) und dem optischen Sensor bewegbar ist

3. Impulsgeber nach einem der vorherigen Ansprüche, **dadurch gekennzeichnet, dass** die erste Impulsgeberplatte (1) linear bewegbar ist und Bereiche unterschiedlicher optischer Dichte, Reflexion oder Transparenz aufweist, die in einem konstanten Abstand (P1) parallel zueinander angeordnet sind.

4. Impulsgeber nach einem der vorherigen Ansprüche, **dadurch gekennzeichnet, dass** die erste Impulsgeberplatte (1) rotatorisch bewegbar ist und Bereiche unterschiedlicher optischer Dichte, Reflexion oder Transparenz aufweist, die auf einer Scheibe um den Mittelpunkt der Scheibe, insbesondere radial oder entlang einer Kurvenbahn, angeordnet sind und zueinander einen konstanten Winkelabstand aufweisen.

5. Impulsgeber nach einem der vorherigen Ansprüche, **dadurch gekennzeichnet, dass** die Bereiche unterschiedlicher optischer Dichte, Reflexion oder Transparenz der ersten oder zweiten Impulsgeberplatte (1,2) durch eine Vielzahl beabstandeter Linien (1a,2a) auf einem transparenten Trägermaterial ausgebildet sind.

6. Impulsgeber nach einem der vorherigen Anspräche, **dadurch gekennzeichnet, dass** eine relative Verdrehung der Impulsgeberplatten (1,2) zueinander manuell, insbesondere mittels einer Mikrometerschraube oder elektrisch gesteuert, insbesondere mittels eines Motors erzeugbar ist.

7. Impulsgeber nach einem der vorherigen Ansprüche, **dadurch gekennzeichnet, dass** mehrere zweite Impulsgeberplatten (2) und mehrere optische Sensoren entlang der ersten Impulsgeberplatte (1) angeordnet sind, wobei die zweiten Impulsgeberplatten (2) jeweils unterschiedliche Winkel (α) zu der ersten Impulsgeberplatte (1) einnehmen können.

8. Verwendung eines Impulsgebers nach einem der vorherigen Ansprüche in einer Druckmaschine, insbesondere einer frei programmierbaren zur Detektion der Lage eines in der Druckmaschine bewegbaren Elementes

## Claims

1. Pulse generator comprising at least one moveable pulse generator plate with periodically repeating areas of different optical density, reflection or transparency, which can be detected by means of at least one optical sensor, which produces an electrical signal depending on the detected area and in which the areas of different optical density, reflection or transparency of a first pulse generator plate (1) with a first periodicity (P1) are overlapped with the areas of different optical density, reflection or transparency of a second pulse generator plate (2) with a second periodicity (P2), for which the first and second pulse generator plate (1, 2) overlap each other at least in an overlapping area (4), so that at least in the overlapping area (4) a moiré pattern of different optical density, reflection or transparency is produced with at least a third periodicity and can be detected with the optical sensor, **characterised in that** the periodicity of the moiré pattern can be adjusted individually again and again by a change in angle (α) of the first and second pulse generator plate (1, 2) to each other.

2. Pulse generator according to claim 1, **characterised in that** the first pulse generator plate (1) can be moved in a linear or rotary way in relation to the second pulse generator plate (2) and the optical sensor.

3. Pulse generator according to one of the previous claims, **characterised in that** the first pulse generator plate (1) can be moved in a linear way and has areas of different optical density, reflection or transparency, which are arranged parallel to each other at a constant distance (P1).

4. Pulse generator according to one of the previous claims, **characterised in that** the first pulse generator plate (1) can be moved in a rotary way and has areas of different optical density, reflection or transparency, which are arranged on a disc around the centre of the disc, particularly in a radial way or along a curved path, and have a constant angular separation from each other.

5. Pulse generator according to one of the previous claims, **characterised in that** the areas of different optical density, reflection or transparency of the first or second pulse generator plate (1, 2) are made of a multiplicity of lines (1a, 2a) at a distance from each other on a transparent carrier material.

6. Pulse generator according to one of the previous claims, **characterised in that** a relative twist of the pulse generator plates (1, 2) to each other can be produced manually, particularly by means of a micrometer screw or controlled electrically, particularly by means of a motor.

7. Pulse generator according to one of the previous claims, **characterised in that** several second pulse generator plates (2) and several optical sensors are arranged along the first pulse generator plate (1), in which the second pulse generator plates (2) may respectively adopt different angles (α) to the first pulse generator plate (1),

8. Use of a pulse generator according to one of the previous claims in a printing press, particularly a freely programmable printing press to detect the position of a moveable element in the printing press.

## Revendications

1. Dispositif de génération d'impulsions comportant au moins une plaque de dispositif de génération d'impulsions mobile comprenant des zones périodiquement répétitives de densité optique, réflexion ou transparence différente, qui peuvent être détectées au moyen d'au moins un capteur optique, qui produit un signal électrique dépendant d'une zone détectée et dans lequel les zones de densité optique, réflexion ou transparence différente d'une première plaque de Dispositif de génération d'impulsions (1) comprenant une première périodicité (P1) sont superposées aux zones de densité optique, réflexion ou transparence différente d'une seconde plaque de dispositif de génération d'impulsions (2) comprenant une deuxième périodicité (P2), la première et la seconde plaques de dispositif de génération d'impulsions (1, 2) se recouvrant pour cela au moins dans une zone de superposition (4), de sorte qu'au moins dans la zone de superposition (4) un motif moiré de densité optique, réflexion ou transparence différente comprenant au moins une troisième périodicité est produit et peut être détecté avec le capteur optique, **caractérisé en ce que** la périodicité du motif moiré peut être réglée individuellement et de façon constamment renouvelée par une modification angulaire (α) de à première et de la seconde plaques de dispositif de génération d'impulsions (1, 2).

2. Dispositif de génération d'impulsions selon la revendication 1, **caractérisé en ce que** la première plaque de dispositif de génération d'impulsions (1) peut être déplacée de manière linéaire ou rotative par rapport à la seconde plaque de dispositif de génération d'impulsions (2) et au capteur optique.

3. Dispositif de génération d'impulsions selon l'une quelconque des revendications précédentes, **caractérisé en ce que** la première plaque de dispositif de génération d'impulsions (1) peut être déplacée de manière linéaire et comprend des zones de densité optique, réflexion ou transparence différente qui sont disposées parallèlement les unes aux autres suivant un écart constant (P1).

4. Dispositif de génération d'impulsions selon l'une quelconque des revendications précédentes, **caractérisé en ce que** la première plaque de dispositif de génération d'impulsions (1) peut être déplacée de manière rotative et comprend des zones de densité optique, réflexion ou transparence différente qui sont disposées sur un disque autour du centre du disque, en particulier de manière radiale ou le long d'une courbe et présentent un écart angulaire constant les unes par rapport aux autres.

5. Dispositif de génération d'impulsions selon l'une quelconque des revendications précédentes, **caractérisé en ce que** les zones de densité optique, réflexion ou transparence différente de la première ou la seconde plaque de dispositif de génération d'impulsions (1, 2) sont réalisées par une pluralité de lignes espacées (1a, 2a) sur un matériau de support transparente.

6. Dispositif de génération d'impulsions selon l'une quelconque des revendications précédentes, **caractérisé en ce qu'**une rotation relative des plaques de dispositif de générateur d'impulsions (1, 2) l'une par rapport à l'autre peut être produite manuellement, en particulier au moyen d'une vis micrométrique ou en étant commandée électriquement, en particulier au moyen d'un moteur.

7. Dispositif de génération d'impulsions selon l'une quelconque des revendications précédentes, **caractérisé en ce que** plusieurs secondes plaques de dispositif de génération d'impulsions (2) et plusieurs capteurs optiques sont disposés le long de la première plaque de dispositif de génération d'impulsions (1), les secondes plaques de dispositif de génération d'impulsion (2) pouvant enfermer respectivement différents angles (α) par rapport à la première plaque de dispositif de génération d'impulsions (1).

8. Utilisation d'un dispositif de génération d'impulsions selon l'une quelconque des revendications précédentes dans une machine à imprimer, en particulier une machine à imprimer librement programmable pour détecter la position d'un élément mobile dans la machine à imprimer.
